# EUROPEAN PATENT APPLICATION

(11) **EP 4 159 445 A1**
(43) Date of publication of application: **05.04.2023**
(21) Application number: 22198098.0
(22) Date of filing: 27.09.2022
(51) Int. Cl.: B41J 2/16, B41J 2/14

(54) **MICROFLUIDIC MEMS DEVICE COMPRISING A BURIED CHAMBER AND MANUFACTURING PROCESS THEREOF**

(30) Priority: 29.09.2021 IT 202100024944
(71) Applicant: STMicroelectronics S.r.l., 20864 Agrate Brianza (MB) (IT)
(72) Inventor: NOMELLINI, Andrea, 20159 Milano (IT); SEGHIZZI, Luca, 20125 Milano (IT)
(74) Representative: Studio Torta S.p.A.

(57) **Abstract**

Process for manufacturing a microfluidic device, wherein a sacrificial layer (32) is formed on a semiconductor substrate (31); a carrying layer (33) is formed on the sacrificial layer; the carrying layer is selectively removed to form at least one release opening (36) extending through the carrying layer; a permeable layer (37) of a permeable semiconductor material is formed in the at least one release opening; the sacrificial layer (32) is selectively removed through the permeable layer (37) to form a fluidic chamber (38; 138); the at least one release opening is filled with non-permeable semiconductor filling material, forming a monolithic body having a membrane region (42); an actuator element is formed on the membrane region and a cap element is attached to the monolithic body and surrounds the actuator element.

## Description

The present invention relates to a microfluidic MEMS device comprising a buried chamber and to the manufacturing process thereof. In particular, in the following description reference will be made to a fluid ejection device, based on piezoelectric technology, such as an inkjet head for printing applications, a microactuator, such as a micropump, and the like.

The microfluidic device, with suitable modifications, may however also be used for the emission of fluids other than ink, e.g. for applications in the biological or biomedical field, for local application of biological material (e.g., DNA) in manufacturing sensors for biological analysis, for fabric or ceramic decoration and in 3D printing and additive manufacturing applications.

Furthermore, it may be a different microactuator, for example a micro-switch and the like.

Multiple types of fluid ejection devices processed with the MEMS (Micro-Electro-Mechanical System) technique are known.

These devices are currently formed by coupling a large number of pre-processed and assembled components in a final manufacturing step.

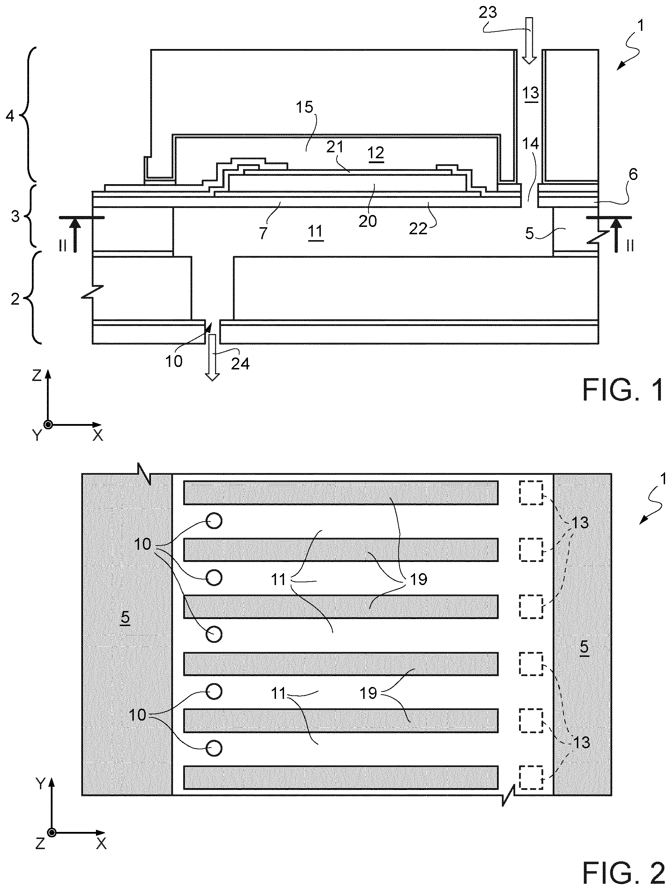

For example, Figure 1 shows an ejection device 1 comprising a nozzle portion 2, a chamber portion 3 and a distribution portion 4, formed from respective semiconductor wafers, mutually superimposed and bonded.

The nozzle portion 2 hats an ejection channel 10 (also referred to as nozzle 10) and delimits downwardly a fluid containment chamber 11.

The chamber portion 3 is formed by a body 5, of silicon, and by a membrane layer 6, e.g. of silicon oxide. The fluid containment chamber 11 is delimited laterally by the body 5 and upwardly by the membrane layer 5. The zone of the membrane layer 5 above the fluid containment chamber 12 forms a membrane 7. The membrane layer 6 is of a thickness such that it may deflect.

The distribution portion 4 is of silicon and upwardly delimits an actuator chamber 12, that is downwardly closed by the membrane layer 5 and superimposed on the fluid containment chamber 11 and on the membrane 7. The distribution portion 4 has a supply channel 13, in communication with the fluid containment chamber 11 through a corresponding opening 14 in the membrane layer 6.

A piezoelectric actuator 15 is arranged above the membrane 7, in the actuator chamber 12. The piezoelectric actuator 15 comprises a pair of electrodes 21, 22, mutually superimposed, having a piezoelectric layer 20, e.g. PZT (Pb, Zr, TiO₃), extending therebetween.

The ejection device 1 may comprise a plurality of fluid containment chambers 11, extending side by side, laterally separated by walls 19, but mutually connected at the ends, as illustrated in Figure 2, which shows a plurality of supply channels 13 with dashed lines and a plurality of ejection channels 10 with solid lines.

In use, a fluid or liquid to be ejected is provided to the fluid containment chamber 11 through the supply channel 13 (arrow 23); the piezoelectric actuator 15 is controlled through the electrodes 21, 22 (suitably biased) in such a way as to generate a deflection of the membrane 7 towards the inside of the fluid containment chamber 11 and a movement of the fluid towards the nozzle 10, causing a controlled ejection of a drop of fluid towards the outside of the ejection device 1 (arrow 24).

Then, the piezoelectric actuator 15 is controlled in the opposite direction, so to increase the volume of the fluid containment chamber 11 and cause further fluid to be drawn.

By cyclically repeating the actuation of the piezoelectric actuator 15, the ejection of further fluid drops is obtained.

The ejection device 1 may be manufactured as described in patent application US 2017/182778. The manufacturing process described therein provides for coupling three, at least partially pre-processed.

This coupling (e.g., by bonding techniques) generally requires high accuracy in order to obtain a good alignment between the wafers and between the functional elements formed therein.

Furthermore, the use of three wafers is expensive and, in some situations, may lead to yield problems and technological difficulties.

Patent application US 2020/0324545 describes a process for manufacturing a fluid ejection device that uses two silicon wafers and a nozzle plate formed by a dry film. Although this solution solves the problem of using three silicon wafers, it is susceptible of improvement, as the material of the nozzle plate is not always able to ensure repeatability and uniformity of the technological process, useful in some applications, and may be incompatible with some liquids. Furthermore, the use of a polymeric material for the nozzle plate may be incompatible with applications where parts operate at low or high temperatures.

The aim of the present invention is to provide a MEMS device which overcomes the drawbacks of the prior art.

According to the present invention, a microfluidic device and the manufacturing process thereof are provided, as defined in the attached claims.

For a better understanding of the present invention, some embodiments thereof are now described, purely by way of non-limiting example, with reference to the attached drawings, wherein:
- Figure 1 is a cross-section of a known fluid ejection device;
- Figure 2 is a horizontal sectional view taken along section line II-II of Figure 1;
- Figures 3A-3I are cross-sections through a fluid ejection device, in subsequent manufacturing steps, according to an embodiment;
- Figures 4A-4D are top-plan views of the device of Figures 3A-3I, in the manufacturing steps of Figures 3A, 3B, 3C and 31, respectively;
- Figures 5A-5I are cross-sections through a fluid ejection device, in subsequent manufacturing steps, according to another embodiment;
- Figures 6A-6I are top-plan views, on a reduced scale, of the device of Figures 5A-5I in the manufacturing steps corresponding to the Figures having the same letter A-I;
- Figures 7A-7D are cross-sections of the device of Figures 5A-5I in the manufacturing steps corresponding to Figures 5B, 5G, 5H and 51, taken along section lines 7A-7A, 7B-7B, 7C-7C and 7D-7D, respectively, of Figures 6B, 6G, 6H and 61;
- Figure 8 shows an enlarged detail of Figure 3D; and
- Figures 9A and 9B are cross-sections of a variant of the device of Figures 3A-3I, in a manufacturing step subsequent to Figure 3C and in a manufacturing step corresponding to Figure 3D, respectively.

The following description refers to the arrangement shown; consequently, expressions such as "above", "below", "top", "bottom", "right", "left" relate to the attached figures and are not to be intended in a limiting manner.

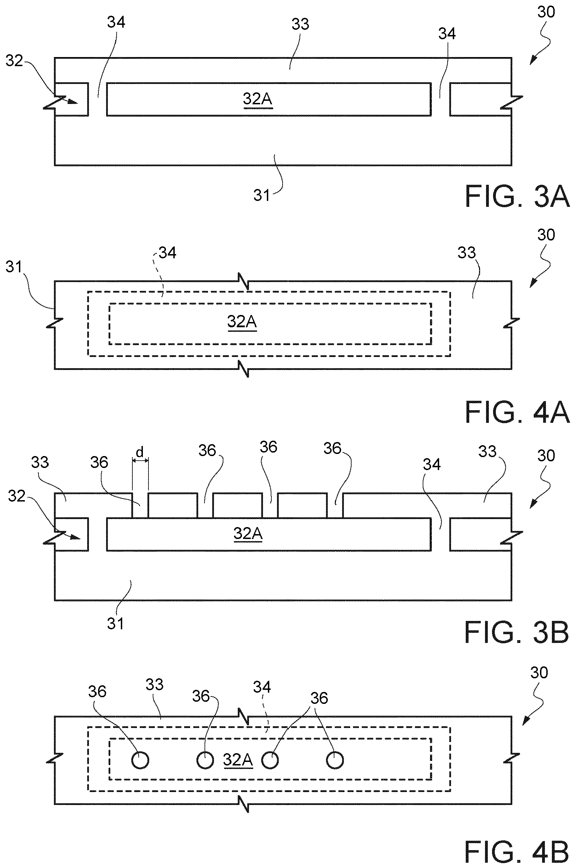

Figures 3A-3I and 4A-4C refer to manufacturing steps for manufacturing a first microfluidic device, for example an ink or other liquid injection head.

Figure 3A shows a first wafer 30 which has already been subject to initial processing steps to form, above a substrate 31, a sacrificial layer 32; a carrying layer 33 extends above the sacrificial layer 32 and has portions 34 extending through the sacrificial layer 32 down to the substrate 31.

The portions 34 of the carrying layer 33 form a closed wall, hereinafter also referred to as stop wall 34, which laterally surrounds a sacrificial portion of the sacrificial layer 32, indicated by 32A, where a cavity is to be formed, as explained in detail below.

For example, the stop wall 34 forms a hollow rectangular wall, as represented in the top view of Figure 4A with dashed line.

In particular, to form the structure of Figures 3A and 4A, the substrate 31, here of monocrystalline silicon, may be subject to oxidation to form the sacrificial layer 32, here, of silicon oxide. The sacrificial layer 32 is selectively etched where it is desired to form the stop wall 34. The carrying layer 33 is grown epitaxially on the sacrificial layer 32 and, in the removed zones, directly on the substrate 31, forming the stop wall 34.

The sacrificial layer 32 may have a thickness comprised between 0.5 and 5 pm, according to the desired depth of the structures to be formed, as described below.

The carrying layer 33 may have a thickness comprised between 1 and 20 µm, according to the expected design characteristics.

In Figures 3B and 4B, the carrying layer 33 is etched to form release holes 36, for example through dry etching.

The release holes 36 extend throughout the thickness of the carrying layer 33 and have, for example, a circular area with a diameter d comprised between 0.5 and 2 µm. The release holes 36 are in a number and at a distance such that they allow, in a subsequent release step, the uniform flow of the etchant and maintain sufficient mechanical solidity of the carrying layer 33. For example, in order to obtain a membrane with a length equal to 25 µm, four release holes 36, arranged along a line, may be formed.

In general, the release holes 36 may be distributed throughout the area of the sacrificial portion 32A, where it is desired to create the cavity, based on technological considerations.

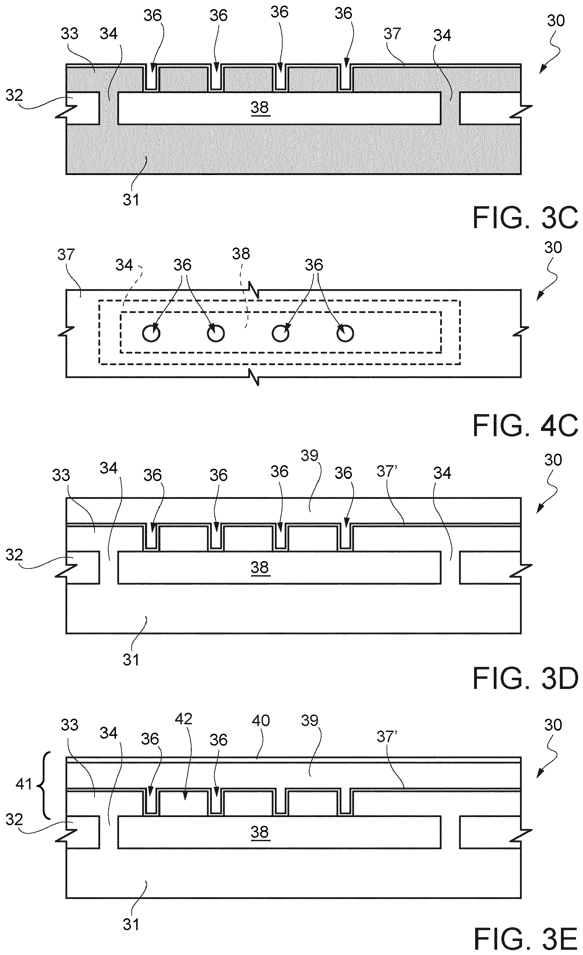

In Figures 3C and 4C, a permeable layer 37 is deposited on the surface of the first wafer 30. The permeable layer 37 is for example of permeable polysilicon, deposited by LPCVD (Low Pressure Chemical Vapor Deposition), with a thickness comprised between 0.06 and 0.2 µm. As described for example in US 5919364A, the polycrystalline silicon deposited by LPCVD with reduced thicknesses has a structure characterized by micro-holes that make it permeable and allow liquids and vapors (in particular etchants such as HF - hydrofluoric acid vapors) to flow.

In particular, the permeable layer 37 coats the walls and the bottom of the release holes 36.

Then, the sacrificial portion 32A is etched using an etchant, for example vapor-phase HF. Due to the permeability of the permeable layer 37, the etchant traverses it and removes the sacrificial portion 32A, arranged below the release holes 36. In this manner, a buried cavity 38 is formed.

The stop wall 34 here laterally stops etching of the sacrificial layer 32, limiting it to the sacrificial portion 32A, and thus forming a wall that delimits the buried cavity 38.

Subsequently, Figure 3D, the buried cavity 38 is sealed by epitaxial deposition of a sealing layer 39 which covers the carrying layer 33 and fills the release holes 36.

To this end, for example, a polycrystalline silicon layer is deposited, with a thickness comprised between 2 and 25 µm, which may be subsequently planarized and thinned, to obtain a desired final thickness, for example a thickness varying between 1 and 24 µm.

During sealing of the release holes 36, the permeable layer 37 forms a barrier against polycrystalline silicon deposition inside the buried cavity 38.

In this step, the permeable layer 37 generally changes crystallographic state and, at the end of the sealing process, it presents a structure that is no longer permeable, but polycrystalline.

Furthermore, at the end of the sealing process, the permeable layer 37 (hereinafter referred to as the non-permeable polycrystalline layer 37') has grains with smaller size than the carrying layer 33 and the sealing layer 39.

In particular, on the average, it may have grains smaller by an order of magnitude than the carrying layer 33 and the sealing layer 39. For example, the grains of the non-permeable polycrystalline layer 37' may have dimensions of 100-500 nm while the grains of the carrying 33 and sealing 39 layers may be 500-5000 nm.

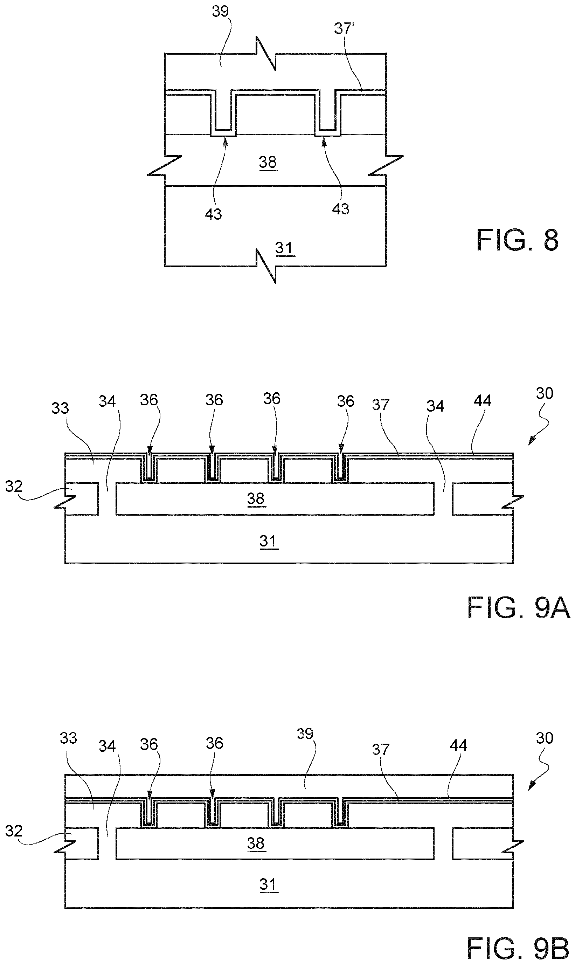

Furthermore, as shown in the detail of Figure 8, because of the growth process of the sealing layer 39, the bottom portion of the non-permeable polycrystalline layer 37' may slightly protrude with respect to the bottom surface of the carrying layer 32, here forming sorts of very small steps 43.

In Figure 3E, an insulating layer 40 is deposited above the sealing layer 39.

For example, the insulating layer 40 may be a silicon oxide layer deposited by CVD, Chemical Vapor Deposition, such as TEOS (tetraethylorthosilicate), with a thickness of about 0.5 µm.

The carrying layer 33, the non-permeable polycrystalline layer 37', the sealing layer 39 and the insulating layer 40 form a membrane layer 41 which, on the buried cavity 38, forms a membrane 42.

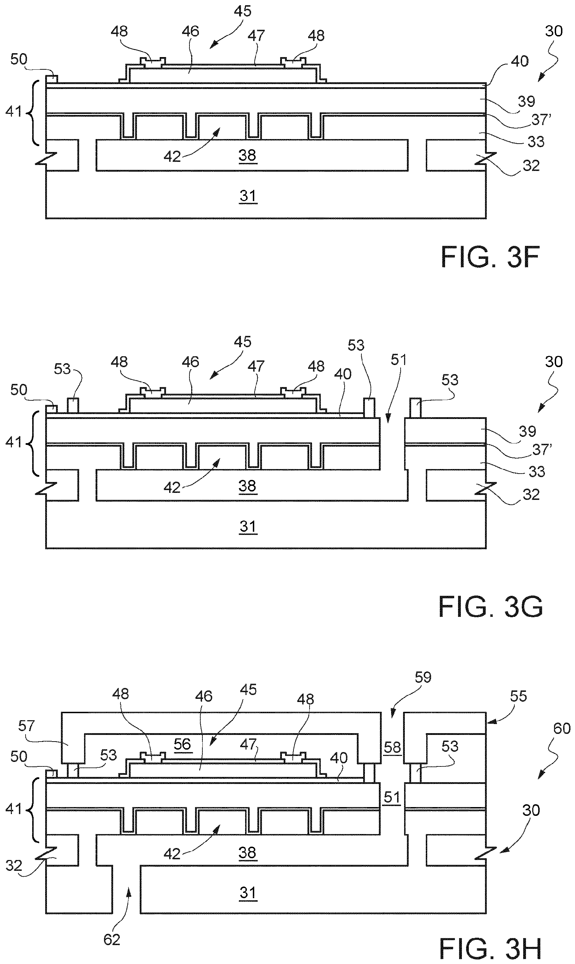

In Figure 3F, an actuator element 45, having for example the structure shown for the piezoelectric actuator 15 of Figure 1, is formed on the membrane 42.

In particular, a bottom electrode layer (e.g., formed by a TiO₂ layer with a thickness comprised between 5 and 50 nm and a Pt layer with a thickness comprised between 30 and 300 nm deposited thereon) is deposited on the insulating layer 40. Then, a piezoelectric layer (for example a PZT -Pb, Zr, TiO3- layer) is deposited, having a thickness comprised between 0.5 and 3.0 µm, typically 1 or 2 µm. Subsequently, a top electrode layer, e.g. Pt or Ir or IrO₂ or TiW or Ru, is deposited above the piezoelectric layer, with a thickness comprised between 30 and 300 nm. The top electrode, piezoelectric and bottom electrode layers are then patterned, to form a stack 46, comprising a bottom electrode and a top electrode, in a known and not shown manner.

In particular, the stack 46 covers almost the entire membrane 42, except for a peripheral frame.

One or more insulation and protection layers, for example, a USG, SiO2 or SiN or Al₂O₃ layer, single or superimposed, is then deposited with a thickness comprised between 10 nm and 1000 nm, forming a protection layer 47.

The protection layer 47 is selectively removed, to form contact openings; then a metal layer is deposited and patterned, to form contact regions 48, in direct electrical contact with the top and bottom electrodes of the stack 46, in a per se known manner. The metal layer also forms conductive tracks and pads 50, shown only schematically, for the electrical connection of the actuator element 45.

In Figure 3G, a fluid opening 51 is formed in the first wafer 30, above the buried cavity 38.

To this end, the membrane layer 41 is etched in a selective manner, by masked etching initially of the oxide of the insulating layer 40 and then, by a dry etching, of the silicon of sealing layer 39, non-permeable polycrystalline layer 37' and carrying layer 33, until reaching the buried cavity 38.

For example, the fluid opening 51 is formed at a first end of the buried cavity 38, making it accessible from the outside.

Furthermore, bonding and sealing regions 53 are formed on the top surface of the wafer 30, on the insulating layer 40 and/or the sealing layer 39.

The bonding and sealing regions 53 may be of polymeric material, such as BCB (Benzocyclobutene) or other suitable material and may be formed by deposition and definition or by molding.

Then, Figure 3H, a cap wafer 55, pre-processed, is bonded to the top face of the first wafer 30, through the bonding and sealing regions 53.

A composite wafer 60 is thus formed.

The cap wafer 55 has been pre-processed so as to already have a recess 56 having a larger area than the actuator element 45 and delimited by a protruding edge 57 intended to couple to the bonding and sealing regions 53.

Furthermore, the cap wafer 55 already has a through opening 58, outside the recess 56.

The recess 56 and the through opening 58 are arranged so that, when the cap wafer 55 is bonded to the first wafer 30, the recess 56 is arranged over the actuator element 45, forming an actuator chamber, again indicated by 56, and the through opening 58 is arranged in continuation with the fluid opening 51, forming a first fluidic channel 59, typically a supply channel.

The cap wafer 55 may also have openings 61 for accessing the pads 50.

Furthermore, the first wafer 30 is etched from the back, for example by dry etching the material of the substrate 31.

A second fluidic channel 62 is thus formed, here an outlet nozzle, which completely passes the substrate 31 and reaches the buried cavity 38, for example at a second end thereof, opposite with respect to the fluid opening 51.

As a result, the buried cavity 38 is now connected with the outside both through the first fluidic channel 59 and through the second fluidic channel 62 and forms a fluidic chamber, indicated again by 38.

Since the fluidic chamber 38 is obtained by partial removal of the sacrificial layer 32, the desired depth for the fluidic chamber 38 determines the thickness of the sacrificial layer 32.

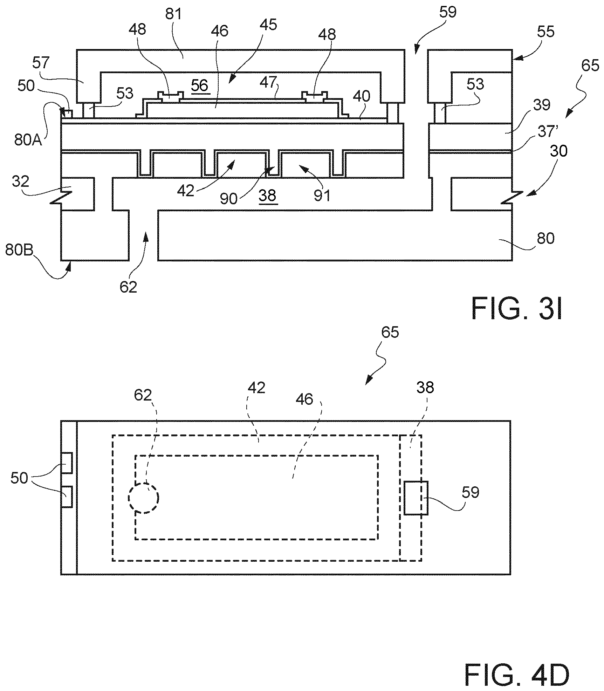

The composite wafer 60 may then be diced to form a microfluidic device 65, as shown in Figures 3I and 4D.

After dicing, the microfluidic device 65 of Figures 3I and 4D therefore comprises a monolithic body 80 formed by the substrate 31, the sacrificial layer 32, the carrying layer 33 and the insulating layer 40.

The monolithic body 80 has a peripheral surface defining a first face 80A (top face, in the drawings) and a second face 80B (bottom face, in the drawings).

A cap element 81 extends above the monolithic body 80 and is attached to the first face 80A.

The membrane 42 comprises a bottom layer including a plurality of first polycrystalline zones 90 and a plurality of second polycrystalline zones 91.

The first polycrystalline zones 90 are formed by the non-permeable polycrystalline layer 37' and by the filling portions of the sealing layer 39 and include a portion facing the fluidic chamber 38 having a finer crystalline structure (at the non-permeable polycrystalline layer 37') and an overlying portion, having a coarser crystalline structure.

The second polycrystalline zones 91 (typically connected) are formed by the carrying layer 33 and have a coarser crystalline structure. In this manner, the microfluidic device 65 is formed from two wafers (first wafer 30 and cap wafer 55) only, and therefore has a simplified structure, that may be formed with simpler steps and at reduced costs.

In use, and in a manner known to the person skilled in the art, a fluid may enter the first fluidic channel 59, traverse the fluidic chamber 38 and exit the second fluidic channel 62 (or vice versa), due to the deformation of the membrane 42, caused by the actuation of the actuator element 45.

In particular, by arranging one of the bonding and sealing regions 53 so that it surrounds the recess 56, after the mutual bonding of the first wafer 30 and the cap wafer 55, the actuator chamber 56 is tight-closed and the actuator element 45 is safely insulated from the external environment.

Furthermore, by arranging one of the bonding and sealing regions 53 so that it surrounds the fluid opening 51, after the mutual bonding of the first wafer 30 and the cap wafer 55, the first fluidic channel 59 is tight-closed with respect to the rest of the device, in particular to the actuator chamber 56.

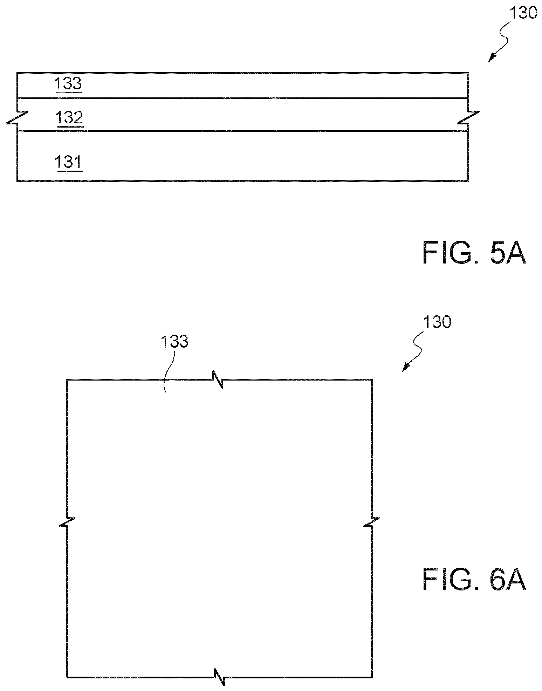

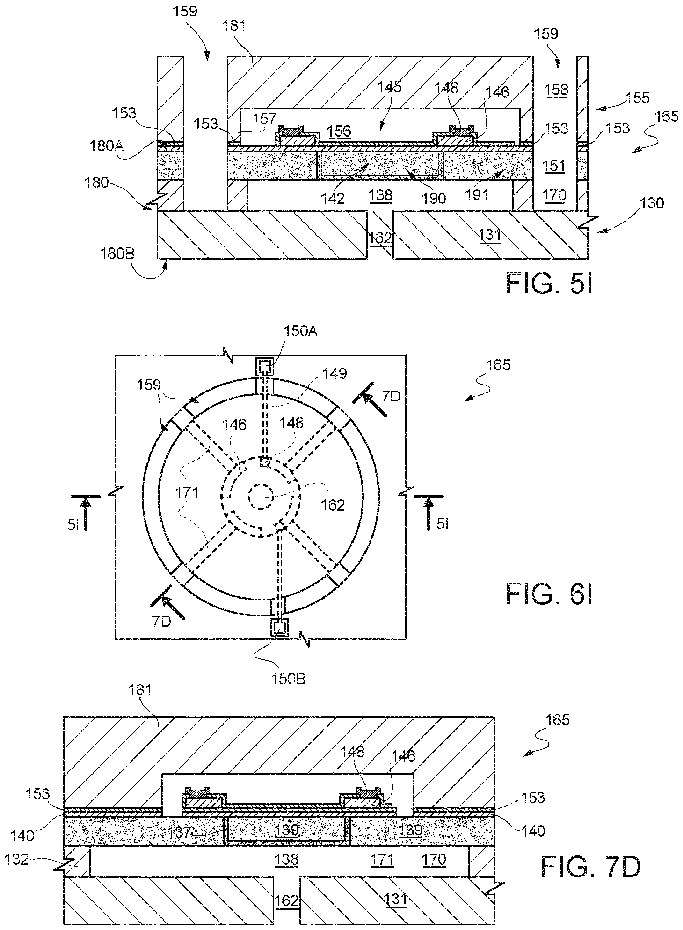

Figures 5A-5I, 6A-6H and 7A-7D refer to manufacturing steps for manufacturing another microfluidic device, for example a micropump.

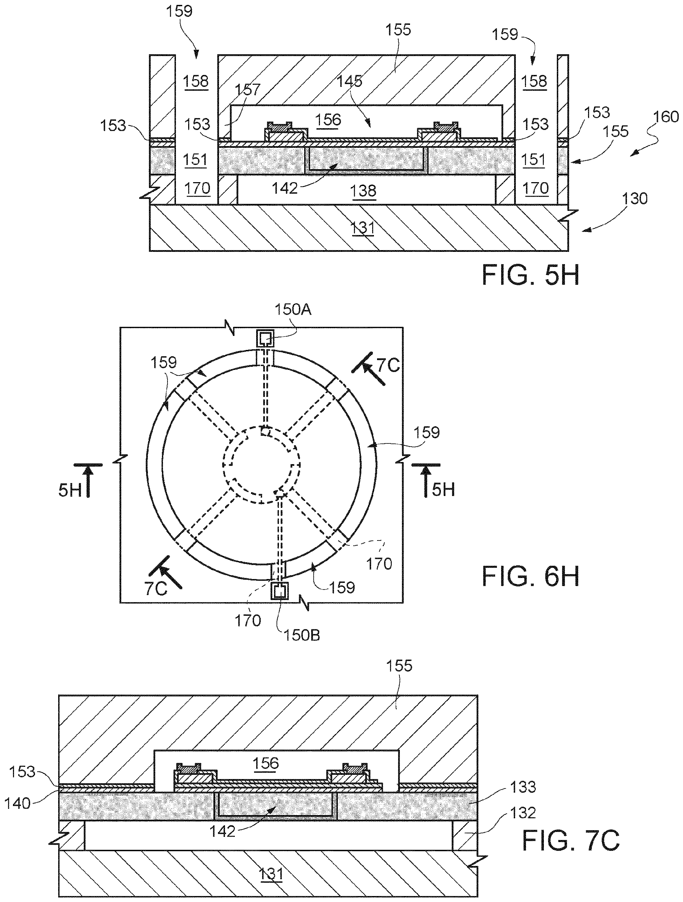

Figures 5A and 6A show a first wafer 130 which has already been subject to initial processing steps to form, above a substrate 131, a sacrificial layer 132 and, thereabove, a carrying layer 133.

The substrate 131 may be for example of monocrystalline silicon; the sacrificial layer 132 may be of silicon oxide, obtained by thermal oxidation and have a thickness comprised between 0.5 and 5 µm (based on the desired depth of the fluidic chamber to be formed); and the carrying layer 133 may have been epitaxially grown and may have a thickness comprised between 1 and 20 µm, based on the elasticity and resistance characteristics desired for the membrane.

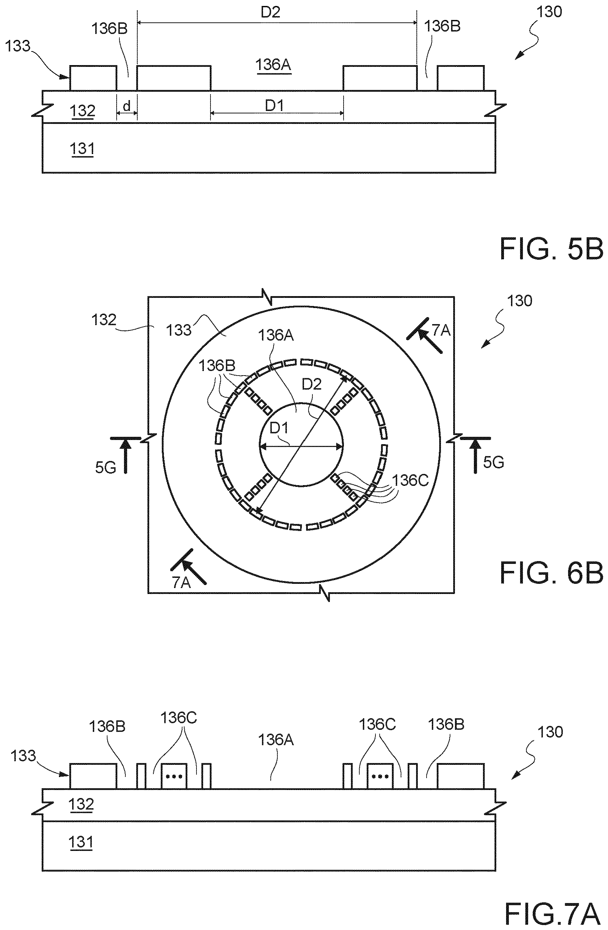

In Figures 5B, 6B and 7A, the carrying layer 133 is etched to form release holes 136A-136C.

In particular, here, a membrane release hole 136A, a plurality of inlet release holes 136B and a plurality of channel release holes 136C are formed. The etching may be a dry etching.

In the illustrated example, as visible in the top view of Figure 6B, the membrane release hole 136A has a circular shape, with a diameter D1 approximately equal to that of the membrane to be formed and for example comprised between 1 and 10 µm.

The inlet release holes 136B are arranged along a closed line, outside the membrane release hole 136A. The inlet release holes 136B may have any shape, e.g. circular, squared, rectangular (or other shape), with a diameter or side comprised between 0.5 and 2 µm and may be arranged at a mutual distance of a few µm (typically, from 0.1 to 0.2 µm) similarly to what has been described for the release holes 36 of Figure 3B. In the example shown, the inlet release holes 136B have the shape of circular ring sectors and are arranged along a circumference that is concentric with the membrane release hole 136A. For example, the circumference (here, the inner circumference) may have a diameter D2 comprised between 20 and 100 µm.

The channel release holes 136C are arranged along radial directions that connect the membrane release hole 136A to the circumference of the inlet release holes 136B. In this embodiment, the channel release holes 136C are arranged along four radial lines, placed at 45° from each other, but other arrangements are possible. The channel release holes 136C may also have a circular or squared shape (or other shape), with a diameter or side comprised between 0.5 and 2 µm and may be arranged at a mutual distance, for example comprised between 0.2 and 0.4 µm.

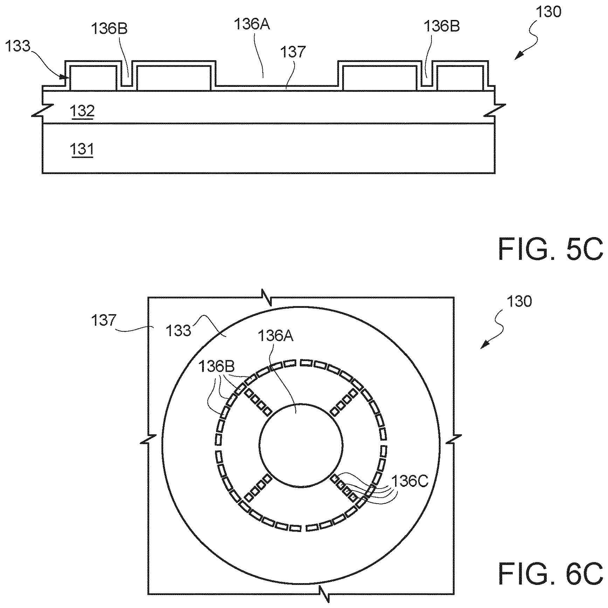

In Figures 5C and 6C, a permeable layer 137 is deposited on the surface of the first wafer 130. The permeable layer 137 is for example of polycrystalline silicon, deposited by LPCVD (Low Pressure Chemical Vapor Deposition), with a thickness comprised between 0.06 µm and 0.2 µm.

As discussed above, the permeable layer 137 has a structure characterized by micro-holes and is therefore permeable to liquids and vapors.

The permeable layer 137 here coats the walls and the bottom of the membrane release holes 136A, the inlet release holes 136B and the channel release holes 136C.

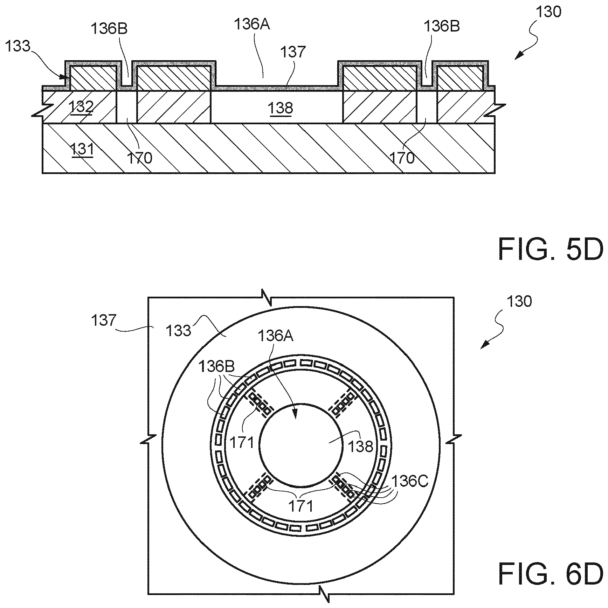

In Figures 5D and 6D, the sacrificial layer 132 is etched using an etchant, for example vapor-phase HF. For example, a time-etching is performed.

Due to the permeability of the permeable layer 137, the etchant traverses it and removes the portions of the sacrificial layer 132 arranged below the release holes 136A-136C and, partially, laterally thereto (in a manner not shown in Figure 5D, for sake of simplicity).

A buried cavity 138 is formed in this manner under the membrane release hole 136A.

An inlet trench 170 is formed under the inlet release holes 136B; in fact these are sufficiently close to each other to cause removal of the material of the sacrificial layer 132 along a continuous line (here, a circumference) having inlet release holes 136B extending therealong.

Furthermore, connection channels 171 (in Figure 6D, four) are formed under the channel release holes 136C. Also here, the channel release holes 136C are sufficiently close to each other to cause the removal of the material of the sacrificial layer 132 seamlessly along the four radial directions of the channel release holes 136C. The connection channels 171 then extend between, and fluidically connect, the buried cavity 138 and the inlet trench 170.

This is represented in Figure 6D, where the buried cavity 138 and the inlet trench 170 are represented with a solid line, for clarity of illustration, and the connection channels 171 are represented with dashed lines.

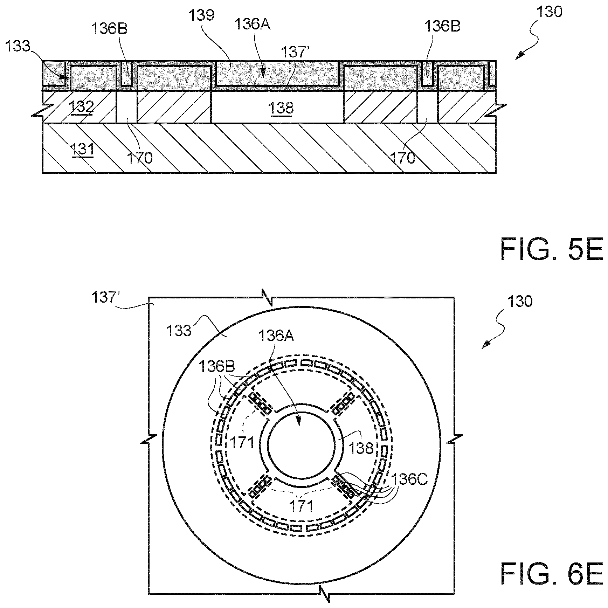

Subsequently, Figures 5E and 6E, the buried cavity 138 is sealed by epitaxial growing a sealing layer 139 which covers the carrying layer 133 and fills the release holes 136A-136C.

To this end, for example, a polycrystalline silicon layer is deposited, with a thickness comprised between 2 and 25 µm, which may subsequently be planarized and thinned. In the embodiment shown, the silicon of the sealing layer 139 outside the release holes 136A-136C is completely removed.

In general, the removal of the sealing layer 139 outside the release holes 136A-136C may not be complete, similarly to what occurs for the sealing layer 39 of Figure 3E.

Also here, in this step, the permeable layer 137 forms a barrier to the polycrystalline silicon deposition inside the buried cavity 138 and modifies its crystallographic structure, turning into a non-permeable polycrystalline layer, with grains having smaller size than the sealing layer 139 and hereinafter indicated by 137'.

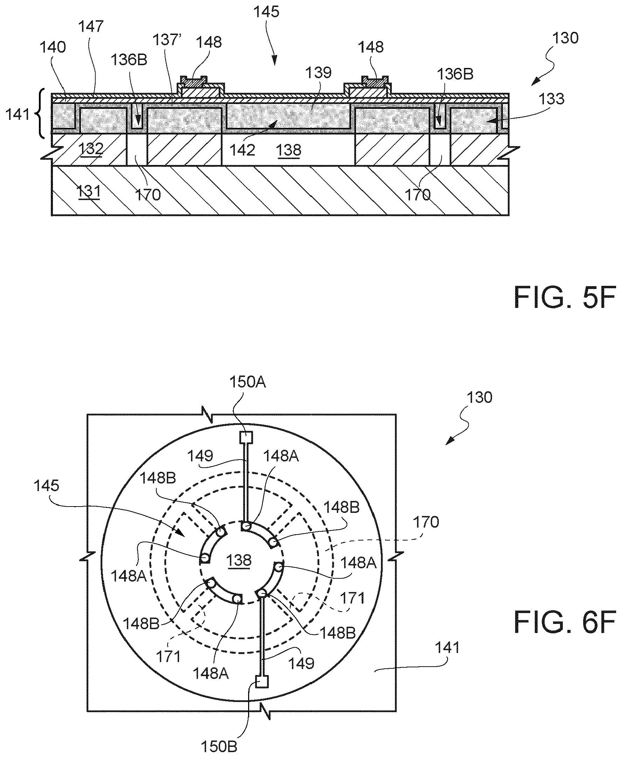

In Figures 5F and 6F, an insulating layer 140 is deposited above the sealing layer 139; an actuator element 145 is formed and electrical connections are formed, as discussed in detail hereinbelow.

The insulating layer 140 may be, also here, a TEOS (tetraethylorthosilicate) layer with a thickness of about 0.5 µm.

The carrying layer 133, the non-permeable polycrystalline layer 137', the sealing layer 139 and the insulating layer 140 thus form a membrane layer 141 which, on the buried cavity 138, forms a membrane 142.

The actuator element 145 may be formed in the manner described above with reference to Figure 3F and therefore comprises a bottom electrode, a piezoelectric layer and a top electrode, not shown.

Here, as visible from Figure 6F, the actuator element 145 has a generally annular shape, comprising a plurality of sections circumferentially spaced from each other, and extends along a peripheral (circumferential) edge of the membrane 142 (Figure 6F).

In Figure 5F, a protection layer 147 is deposited above the actuator element 145 and is opened where the contacts are to be formed, as previously described with reference to Figure 3F.

A metal layer is then deposited and patterned to form contact regions (indicated, in Figure 5F, generally by 148 and, in Figure 6F, by 148A for the contact with the bottom electrode and by 148B for the contact with the top electrode). Conductive tracks 149 and pads 150A, 150B (Figure 6F) are also formed, in a manner that is obvious to the person skilled in the art.

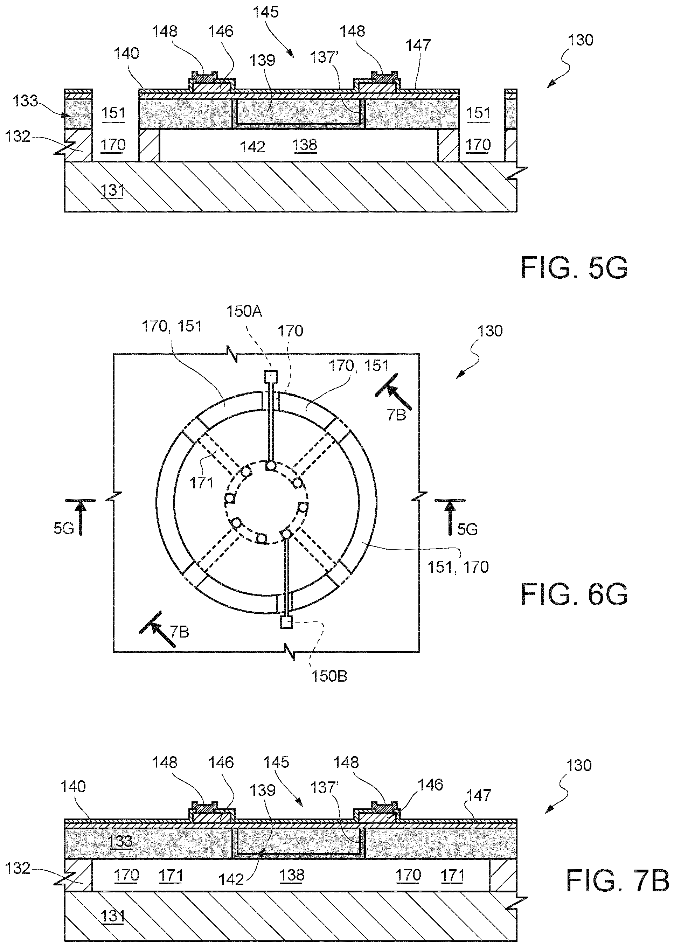

In Figures 5G, 6G and 7B, fluid openings 151 are formed in the first wafer 130.

The fluid openings 151 extend annularly into the membrane layer 141 and are arranged vertically aligned with the inlet trench 170. Alternatively, a single fluid opening 151, that is complete-ring shaped, may be formed.

To this end, the membrane layer 141 is etched in a selective manner, first by etching the protection layer 147 and the insulating layer 140 and then, by dry etching the silicon of the sealing layer 139 and of the non-permeable polycrystalline layer 137', at the inlet release holes 136B (Figure 5F), until reaching the inlet trench 170.

The connection channels 171 are thus formed and put the buried cavity 138 in communication with the outside through the trench 170 (Figures 6G, 7B).

In Figures 5H, 6H and 7C, bonding and sealing regions 153 are formed on the top surface of the wafer 130.

Then, a cap wafer 155, previously processed, is bonded to the top face of the first wafer 130, through the bonding and sealing regions 153, thus forming a composite wafer 160.

In particular, the cap wafer 155 has a recess 156 with a greater area than the actuator element 145; the recess 156 is delimited by a protruding edge 157 which couples to the bonding and sealing regions 153.

Furthermore, the cap wafer 155 already has a plurality of through openings 158, arranged externally to the recess 156 and crossing the protruding edge 157.

The recess 156 and the fluid openings 151 are arranged so that, when the cap wafer 155 is bonded to the first wafer 130, the recess 156 is arranged over the actuator element 145, forming an actuator chamber, indicated again by 156, and the through openings 158 are arranged in continuation with the fluid openings 151. The through openings 158 and the fluid openings 151 together form first fluidic channels 159, typically supply channels, directly connected to the fluidic chamber 138 through the inlet trench 170 and the connection channels 171.

The cap wafer 155 may also have openings for accessing the pads 150, in a manner not shown.

In this manner, the actuator chamber 156 is sealed with respect to the outside and to the fluidic path defined by the fluid chamber 138, the connection channels 171 and the first fluidic channels 159 and tightly encloses the actuator element 145.

In Figures 51, 6I and 7D, the first wafer 130 is etched from the back, e.g. by dry etching.

A second fluidic channel 162, typically an outlet opening, is thus formed, completely crosses the substrate 131 and reaches the fluidic chamber 138, e.g. in the center.

As a result, the fluidic chamber 138 is now connected with the outside both through the first fluidic path 171-170-159 and through the second fluidic channel 162.

The composite wafer 160 may then be diced to form a microfluidic device 165.

After dicing, the microfluidic device 165 of Figures 51, 6I and 7D comprises a monolithic body 180 having a peripheral surface defining a first face 180A (top face, in Figure 51) and a second face 180B (bottom face, in Figure 51) .

The monolithic body 180 is formed here by the substrate 131, the sacrificial layer 132, the carrying layer 133 and the insulating layer 140.

A cap element 181 extends above the monolithic body 180 and is attached to the first face 180A of the monolithic body 180.

In this case, the membrane 142 is formed by a first polycrystalline zone 190 and by a second polycrystalline zone 191.

The first polycrystalline zone 190 comprises the non-permeable polycrystalline layer 137', having a finer crystalline structure, and the filling portions of the sealing layer 139, having coarser crystalline structure.

The second polycrystalline zone 191 is formed by the carrying layer 133, surrounding the first polycrystalline zone 190 and having a coarser crystalline structure, similar to the sealing layer 139.

In use, and in a manner known to the person skilled in the art, by actuating the actuator element 145, the membrane 142 may be deflected so as to draw a fluid through the first fluidic channels 159 and the connection channels 170 towards the fluidic chamber 138; the liquid may then be pumped outwards through the second fluidic channel 162 (or vice versa).

In particular, during use, the actuator chamber 156 is tight-closed and the bonding and sealing regions 153 safely insulate the actuator element 145 from the external environment.

According to a different embodiment, an insulating layer may be deposited on the permeable layer before the formation of the sealing layer.

For example, Figure 9A shows a variant of the microfluidic device of Figures 3A-3I, in an intermediate manufacturing step between those of Figures 3C and 3D.

In detail, here, after forming the buried cavity 38, an insulating layer 44, for example of oxide, is deposited above the permeable layer 37.

Then, Figure 9B, the sealing layer 39 is formed and covers the carrying layer 33, the permeable layer 37 and the insulating layer 44, filling the release holes 36.

In this case, the permeable layer 37 tends to maintain the previous permeability and crystallographic state characteristics.

Owing to the use of only two wafers, the described microfluidic device may be manufactured at low costs and in a simpler manner, reducing alignment operations between the wafers, and therefore with high yield.

Furthermore, processing only two wafers allows the use of a lower number of masks compared to a three-wafer process.

Finally, it is clear that modifications and variations may be made to the microfluidic device and to the manufacturing process described and illustrated herein without thereby departing from the scope of the present invention, as defined in the attached claims.

For example, the inlet and outlet channels might extend from a same face of the body accommodating the fluidic chamber 38, 138.

In addition, the microfluidic device may have a single inlet/outlet channel and operate as a buffer in a fluidic circuit.

The microfluidic device may comprise a plurality of fluidic chambers, in particular in case of manufacturing an inkjet head, arranged side by side and in connection with the ends, as shown in Figure 2.

For example, the different embodiments described may be combined to provide further solutions. For example, the variant of Figures 9A and 9B also applies to the microfluidic device of Figures 5A-5I.

Example embodiments of the present invention are summarized here. Other embodiments can also be understood from the entirety of the specification and the claims filed herein.

A microfluidic device (65; 165) may be summarized as including a monolithic body (80; 180) having a peripheral surface defining a first face (80A; 180A); a fluidic chamber (38; 138) in the monolithic body; a first fluid opening (51; 151, 170) extending from the peripheral surface of the monolithic body and in fluidic communication with the fluidic chamber; a cap element (81; 181) extending above the monolithic body and attached to the first face; an actuator chamber (56; 156) extending between the cap element and the first face of the monolithic body; a membrane region (42; 142) in the monolithic body, the membrane region extending between the first face and the fluidic chamber; a piezoelectric actuator element (45; 145) extending on the first face, above the membrane region, inside the actuator chamber, wherein the membrane region (42; 142) includes at least one first zone (90; 190) and one second zone (91; 191), the at least one first zone (90; 190) including a first portion (37; 137'), facing the fluidic chamber, of polycrystalline silicon having a first crystallographic structure and a second portion (39; 139), of polycrystalline silicon, overlying the first portion and having a second crystallographic structure, and the second zone (91; 191) including a third portion (33; 133), facing the fluidic chamber (38; 138), of polycrystalline silicon having a third crystallographic structure, the first crystallographic structure having a smaller average granularity than the second and the third crystallographic structures.

The at least one first zone (90, 190) may be surrounded by the second zone (91; 191).

The at least one first zone (90) may include a plurality of first zones and the second zone (91) may include a plurality of holes (36), each surrounding a respective first zone (90).

The membrane region (42; 142) may include a stack including a carrying layer (33; 133) of silicon, a permeable layer (37; 137) of silicon, a sealing layer (39; 139) of silicon and an insulating layer (44) of insulating material, wherein, at the first zone (90, 190), the permeable layer (37; 137) may form the first portion, the insulating layer (44; 144) may overly the permeable layer (37; 137) and the sealing layer (39; 139) may form the second portion and may overly the insulating layer (44; 144), and, at the second zone, the carrying layer (33; 133) may form the third portion, the permeable layer (37; 137) may overly the carrying layer (33; 133) and the insulating layer (44) may overly the permeable layer (37; 137).

At the second zone (91), the sealing layer (39) may overly the insulating layer (44).

The at least one first zone (90, 190) may form a step (43) protruding towards the inside of the fluidic chamber (38; 138) with respect to the second zone (91; 191).

The first fluid opening (51; 151) may extend between the fluidic chamber (38; 138) and the first face (80A, 180A) of the monolithic body (80; 180), the microfluidic device (65; 165) may further include a second fluid opening (62; 162) extending through the monolithic body (80; 180) between a second face (80B; 180B) of the monolithic body (80; 180) and the fluidic chamber (38; 138).

The microfluidic device may form a fluid ejection device, a micropump, a microswitch, a fluidic buffer device.

A process for manufacturing a microfluidic device may be summarized as including forming a sacrificial layer (32; 132) on a semiconductor substrate (31; 131); forming a carrying layer (33; 133) on the sacrificial layer, the carrying layer being of non-permeable semiconductor material; selectively removing the carrying layer to form at least one release opening (36; 136A) extending through the carrying layer; forming a permeable layer (37; 137) of a permeable semiconductor material in the at least one release opening; selectively removing the sacrificial layer (32; 132) through the permeable layer (37; 137) in the at least one release opening and forming a fluidic chamber (38; 138); filling the at least one release opening with non-permeable semiconductor filling material, thereby forming a monolithic body (80; 180) having a peripheral surface defining a first face (80A; 180A) and including a membrane region (42; 142) extending between the first face and the fluidic chamber; forming a piezoelectric actuator element on the first face of the monolithic body, on the membrane region; forming a first fluidic opening (51; 151) extending into the carrying layer (33, 133) until the fluidic chamber; and attaching a cap element to the first face of the monolithic body, the cap element having a recess defining, together with the monolithic body, an actuator chamber surrounding the piezoelectric actuator element.

The membrane region (42; 142) may include at least one first zone (90; 190) and one second zone (91; 191), the at least one first zone (90; 190) may include a first portion (37; 137'), of polycrystalline silicon, facing the fluidic chamber and having a first crystallographic structure, and a second portion (39; 139), of polycrystalline silicon, overlying the first portion and having a second crystallographic structure, and the second zone (91; 191) may include a third portion (33; 133), of polycrystalline silicon. facing the fluidic chamber (38; 138) and having a third crystallographic structure, the first crystallographic structure having a smaller average granularity than the second and the third crystallographic structures.

Forming a permeable layer (37; 137) may include depositing a polycrystalline silicon layer by LPCVD.

The permeable layer (37; 137) may have a thickness between 0.06 and 0.2 µm.

Filling the at least one release opening may include epitaxially growing a sealing layer (39; 139).

The sealing layer (39; 139) may have a thickness between 2 and 25 µm.

The process may further include, after selectively removing the sacrificial layer (32; 132) and before filling the at least one release opening (34; 134), depositing an insulating layer (44) such as silicon oxide.

## Claims

1. A microfluidic device (65; 165) comprising:
a monolithic body (80; 180) having a peripheral surface defining a first face (80A; 180A);
a fluidic chamber (38; 138) in the monolithic body;
a first fluid opening (51; 151, 170) extending from the peripheral surface of the monolithic body and in fluidic communication with the fluidic chamber;
a cap element (81; 181) extending above the monolithic body and attached to the first face;
an actuator chamber (56; 156) extending between the cap element and the first face of the monolithic body;
a membrane region (42; 142) in the monolithic body, the membrane region extending between the first face and the fluidic chamber; and
a piezoelectric actuator element (45; 145) extending on the first face, above the membrane region, inside the actuator chamber,
wherein the membrane region (42; 142) comprises at least one first zone (90; 190) and one second zone (91; 191), the at least one first zone (90; 190) including a first portion (37; 137'), facing the fluidic chamber, of polycrystalline silicon having a first crystallographic structure and a second portion (39; 139), of polycrystalline silicon, overlying the first portion and having a second crystallographic structure, and the second zone (91; 191) including a third portion (33; 133), facing the fluidic chamber (38; 138), of polycrystalline silicon having a third crystallographic structure, the first crystallographic structure having a smaller average granularity than the second and the third crystallographic structures.

2. The microfluidic device according to claim 1, wherein the at least one first zone (90, 190) is surrounded by the second zone (91; 191).

3. The microfluidic device according to claim 1, wherein the at least one first zone (90) comprises a plurality of first zones and the second zone (91) comprises a plurality of holes (36), each surrounding a respective first zone (90).

4. The microfluidic device according to any of the preceding claims, wherein the membrane region (42; 142) comprises a stack including a carrying layer (33; 133) of silicon, a permeable layer (37; 137) of silicon, a sealing layer (39; 139) of silicon and an insulating layer (44) of insulating material,
wherein, at the first zone (90, 190), the permeable layer (37; 137) forms the first portion, the insulating layer (44; 144) overlies the permeable layer (37; 137) and the sealing layer (39; 139) forms the second portion and overlies the insulating layer (44; 144),
and, at the second zone, the carrying layer (33; 133) forms the third portion, the permeable layer (37; 137) overlies the carrying layer (33; 133) and the insulating layer (44) overlies the permeable layer (37; 137).

5. The microfluidic device according to the preceding claim, wherein, at the second zone (91), the sealing layer (39) overlies the insulating layer (44).

6. The microfluidic device according to any of the preceding claims, wherein the at least one first zone (90, 190) forms a step (43) protruding towards the inside of the fluidic chamber (38; 138) with respect to the second zone (91; 191).

7. The microfluidic device according to any of the preceding claims, wherein the first fluid opening (51; 151) extends between the fluidic chamber (38; 138) and the first face (80A, 180A) of the monolithic body (80; 180), the microfluidic device (65; 165) further comprising a second fluid opening (62; 162) extending through the monolithic body (80; 180) between a second face (80B; 180B) of the monolithic body (80; 180) and the fluidic chamber (38; 138).

8. The microfluidic device according to any of the preceding claims, forming a fluid ejection device, a micropump, a microswitch, a fluidic buffer device.

9. A process for manufacturing a microfluidic device comprising:
forming a sacrificial layer (32; 132) on a semiconductor substrate (31; 131);
forming a carrying layer (33; 133) on the sacrificial layer, the carrying layer being of non-permeable semiconductor material;
selectively removing the carrying layer to form at least one release opening (36; 136A) extending through the carrying layer;
forming a permeable layer (37; 137) of a permeable semiconductor material in the at least one release opening;
selectively removing the sacrificial layer (32; 132) through the permeable layer (37; 137) in the at least one release opening and forming a fluidic chamber (38; 138);
filling the at least one release opening with non-permeable semiconductor filling material, thereby forming a monolithic body (80; 180) having a peripheral surface defining a first face (80A; 180A) and including a membrane region (42; 142) extending between the first face and the fluidic chamber;
forming a piezoelectric actuator element on the first face of the monolithic body, on the membrane region,
forming a first fluidic opening (51; 151) extending into the carrying layer (33, 133) until the fluidic chamber; and
attaching a cap element to the first face of the monolithic body, the cap element having a recess defining, together with the monolithic body, an actuator chamber surrounding the piezoelectric actuator element.

10. The process according to the preceding claim, wherein the membrane region (42; 142) comprises at least one first zone (90; 190) and one second zone (91; 191), the at least one first zone (90; 190) including a first portion (37; 137'), of polycrystalline silicon, facing the fluidic chamber and having a first crystallographic structure, and a second portion (39; 139), of polycrystalline silicon, overlying the first portion and having a second crystallographic structure, and the second zone (91; 191) including a third portion (33; 133), of polycrystalline silicon. facing the fluidic chamber (38; 138) and having a third crystallographic structure, the first crystallographic structure having a smaller average granularity than the second and the third crystallographic structures.

11. The process according to claim 9 or 10, wherein forming a permeable layer (37; 137) comprises depositing a polycrystalline silicon layer by LPCVD.

12. The process according to any of claims 9-11, wherein the permeable layer (37; 137) has a thickness comprised between 0.06 and 0.2 µm.

13. The process according to any of claims 9-12, wherein filling the at least one release opening comprises epitaxially growing a sealing layer (39; 139).

14. The process according to the preceding claim, wherein the sealing layer (39; 139) has a thickness comprised between 2 and 25 µm.

15. The process according to any of claims 9-14, further comprising, after selectively removing the sacrificial layer (32; 132) and before filling the at least one release opening (34; 134), depositing an insulating layer (44) such as silicon oxide.
